Europäisches Patentamt

(19) European Patent Office

Office européen des brevets

(11) EP 0 746 040 A1

(12) EUROPEAN PATENT APPLICATION

(43) Date of publication:
04.12.1996 Bulletin 1996/49

(51) Int. Cl.$^6$: H01L 29/739

(21) Application number: 95830228.3

(22) Date of filing: 31.05.1995

(84) Designated Contracting States:
DE FR GB IT

(71) Applicant: CO.RI.M.ME.
CONSORZIO PER LA RICERCA SULLA
MICROELETTRONICA NEL MEZZOGIORNO
I-95121 Catania (IT)

(72) Inventors:
• Fragapane, Leonardo
  I-95100 Catania (IT)
• Frisina, Ferruccio
  I-95100 Catania (IT)

(54) Improved IGBT device

(57)     A semiconductor power device comprising an isolated gate bipolar transistor, of the type which comprises a semiconductor substrate with a first type of conductivity and an overlying epitaxial layer with a second type of conductivity, opposite from the first, and whose junction to the substrate forms the base/emitter junction of the bipolar transistor, has the junction formed by a layer of semiconductor material with conductivity of the second type but a higher concentration of dopant than that of the epitaxial layer.

Furthermore, the device has the epitaxial layer with conductivity of the second type provided with at least two zones at different dopant concentrations, namely a first lower zone being part of the junction and having a higher dopant concentration, and a second upper zone having a lower concentration.

FIG.7

FIG.4

EP 0 746 040 A1

## Description

### Field of the Invention

The present invention is directed to isolated gate bipolar devices, commonly known as IGBTs, or modulated-conductivity MOS power devices.

More particularly, the invention relates, but not solely, to IGBT devices having enhanced features of rugged construction, conductivity modulation, and speed.

The description which follows will make reference to this application for convenience of illustration.

### Prior Art

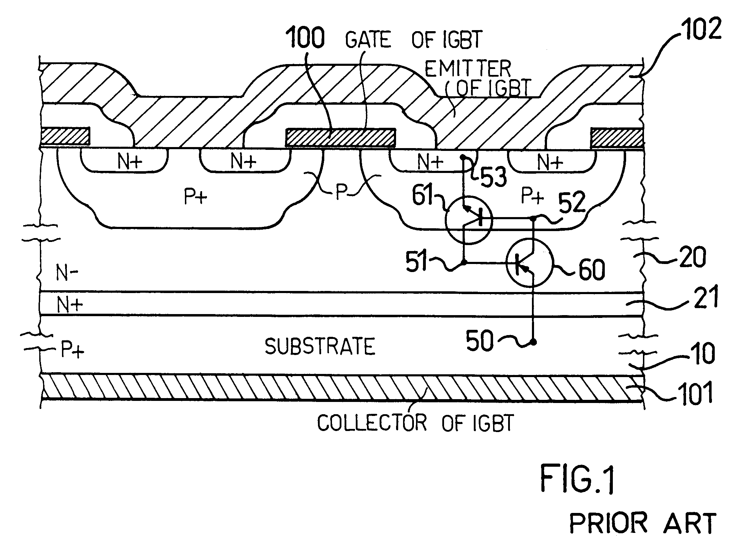

As is well known, from a functional standpoint, an IGBT device is considered to be the equivalent of a MOSFET transistor driving a bipolar power transistor, for instance as shown in Figure 1 of this application which is reproduced from Klaus Rischmuller's publication "PCIM90 EUROPE". Power Conversion Conference, June '90.

A description of the basics of the operation of an IGBT type of structure is given in US Patent 4,495,493.

A different embodiment which brings out other features of the same IGBT device is described in US Patent 5,073,511.

Still more problems are dealt with in Italian Patent 1241049.

From the above-referenced prior art, it can be evinced that the following are among the advantages afforded by an IGBT device:

ruggedness,

speed or relative fall time, and

conductivity modulation or relative output resistance.

Also known is that conductivity modulation is dependent on the injection of minority carriers from the P+ layer, designatd 10 in Figure 1, into the resistive layer 20 of the N- type, also shown in Figure 1.

This lowers the device output resistance accordingly.

It follows that a reduction in conductivity modulation, resulting from a reduction in the gain of transistor 60 which is a parasitic PNP transistor intrinsic to the IGBT device and shown in Figure 1, will in turn result in increased output resistance of the device.

Also known is that an IGBT device has an output resistance, or VCEsat directly tied to it, which increases with the breakdown voltage of the device.

Also known is the relationship of breakdown voltage to the thickness of the epitaxial layer and its dopant concentration. This can be expressed as follows:

$$BV = [q \, C \, X^{**}2]/[2 \, e] \qquad (1)$$

where: BV is the breakdown voltage; C is the dopant concentration in the epitaxial layer; X is the actual thickness of the epitaxial layer, i.e. the overall thickness less the thickness of the deep body layer P+; q is the electron charge; and e is the dielectric constant of silicon.

To increase the conductivity modulation of an IGBT device and concurrently decrease its output resistance, is to provide a better IGBT device.

One viable prior approach to increasing conductivity modulation used to be a decreased doping of the N+ layer 21 which corresponds to the base of the PNP parasitic transistor 60, shown in Figure 1, so as to turn it into a high gain transistor.

However, this involves, as the skilled one will recognize, an increase in the re-combination time of the minority carriers, and this is a variable which is inversely proportional to the device "speed".

Accordingly, this first solution is only practicable on condition that a compromise can be struck, between the increase in conductivity modulation and corresponding increase in turn-off time, which represents an improvement over the basic device.

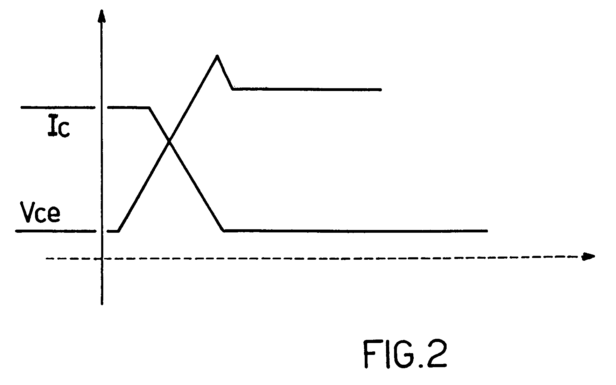

Let's consider now ruggedness, which is defined as the device ability not to destroy itself when, during a turn-off under an inductive load, it is called upon to dissipate the power related to the product of voltage by current at the crossing point of the two curves, as shown in Figure 2.

Also referring to Figure 1, the parasitic thyristor of the structure, made of the two transistors 60, of the PNP type, and 61, of the NPN type.

The triggering of this parasitic thyristor at a given current value (called the latch-up current) restricts the safe range of the device.

The gain of the transistor 60 is resolutive for the control of the parasitic thyristor triggering, which in turn provides a measure of the IGBT device ruggedness.

As previously mentioned, gain is controlled by acting on the equivalent of the base of the PNP transistor 60 that is the layer 20 shown in Figure 1.

It follows that, to improve the ruggedness of the IGBT device, a transistor 60 with low gain will be aimed at, e.g. by increasing the dopant dose to the N+ layer 21.

However, this manipulation of the dopant dose will act in an inversely proportional manner on the output resistance for the reasons given above in connection with conductivity modulation.

It is evident, therefore, that any improvement of the device ruggedness would be at the expense of the other significant variable, namely conductivity modulation, and vice versa.

There is another known method of acting on the output resistance, speed and ruggedness variables without altering the breakdown voltage value.

This consists of acting on the thickness of the N- layer 20.

It will be recalled that it depends on breakdown voltage according to relation (1).

The thickness of the layer 20 is known, from the physics of semiconductor electronic devices, specifically of IGBTs, to be directly proportional to the re-combination time of the minority carriers.

It follows that that thickness is inversely proportional to the device speed.

In addition, by the same laws of physics, the thickness of the layer 20 is tied in a directly proportional manner to the output resistance of the device.

In light of the foregoing, it can be evinced that the conductivity modulation can be improved, or the output resistance lowered, by decreasing the thickness of the layer 20, to concurrently improve the device speed as well.

Based on relation (1), this would result in a decreased breakdown voltage.

Also according to relation (1), it would be possible to keep the same breakdown voltage by suitably reducing the thickness of the layer 20, while increasing its resistivity by a raise in the dopant dose.

While being in many ways advantageous, the last-mentioned solution has a drawback in that it implies a considerable reduction of the resultant device ruggedness due to the strong electric field which is present at the interface between the N- layer 20 and N+ layer 21.

This is indorsed by the following relation (2), which expresses the electric field in the semiconductor material as a function of the thickness of the N- layer 20:

$$\frac{dE}{dX} = \frac{q \cdot C}{e} \qquad (2)$$

It is evinced from this relation that a decreased thickness and concurrently increased resistivity for the layer 20 is unproposable because this would seriously impair the device ruggedness.

The underlying technical problem of this invention is to provide an IGBT device with such functional and structural features as to yield improved conductivity modulation and ruggedness for the same breakdown voltage, thereby overcoming the limitations and/or drawbacks mentioned above in connection with the prior art.

## Summary of the Invention

The technical problem is solved by a device as specified above, namely a semiconductor power device comprising an isolated gate bipolar transistor, which is comprised of a semiconductor substrate having a first type of conductivity and an overlying epitaxial layer having a second type of conductivity, which is opposite to the first, and whose junction to the substrate constitutes the base/emitter junction of the bipolar transistor, said junction comprises a layer of a semiconductor material of said second type but having a higher dopant concentration than that of the epitaxial layer, characterized in that the epitaxial layer with conductivity of the second type has at least two zones with increasing concentration, namely a first lower zone being part of the junction and having a higher dopant concentration and a second upper zone having a lower concentration.

More particularly, the invention contemplates the provision of an additional layer having a concentration intermediate those of the N- and N+ layers.

This additional layer locates between a first layer of the device forming the base of the PNP transistor and the buffer layer which separates the base region from the layer forming the emitter of the PNP transistor.

Advantageously, this structure is aimed at reducing the electric field at the interface between the N- and N+ layers corresponding to the prior art layers 20, 21 and to the layers 22, 21 of the invention, with the result of bringing it close to a zero value.

In this way, the layer 23 can be provided with a very high resistivity, that is less doped.

The thickness of the layer 23, therefore, can be greatly reduced while contributing, as per relation (1), toward holding the breakdown voltage of the device at the same level.

The features and advantages of the device according to the invention will appear from the following description of an embodiment thereof, given by way of example and not of limitation with reference to the accompanying drawings.

## Brief Description of the Drawings

Figure 1 shows an IGBT device according to the prior art;

Figure 2 shows the power dissipated by an IGBT;

Figures 3a to 3f illustrate typical successive steps of the process to make IGBT devices;

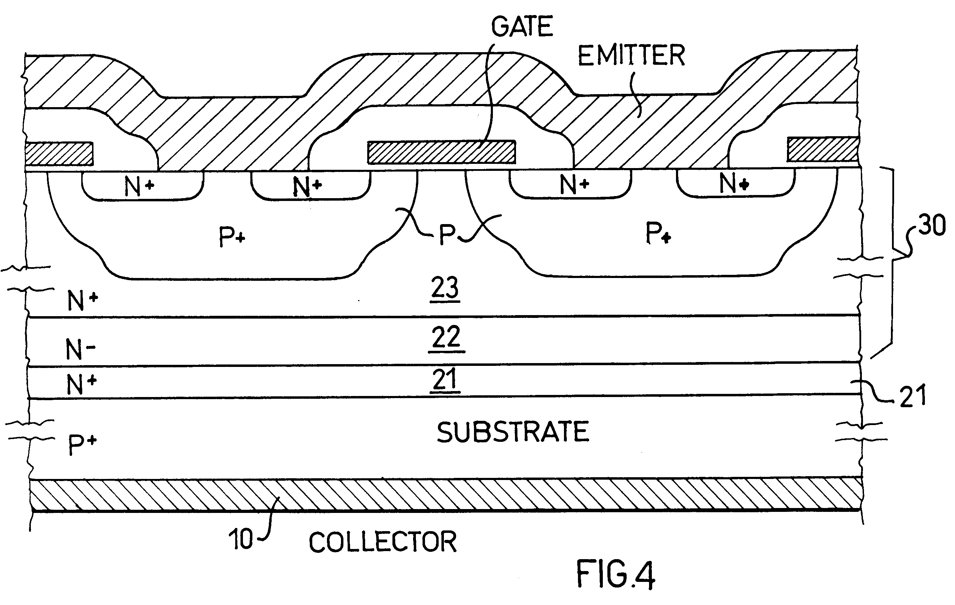

Figure 4 shows an IGBT device according to the invention;

Figure 5 shows the concentration provided in the prior art;

Figure 6 shows the electric field upon breakdown according to the prior art;

Figure 7 shows the concentration provided by this invention;

Figure 8 shows the electric field upon breakdown according to this invention;

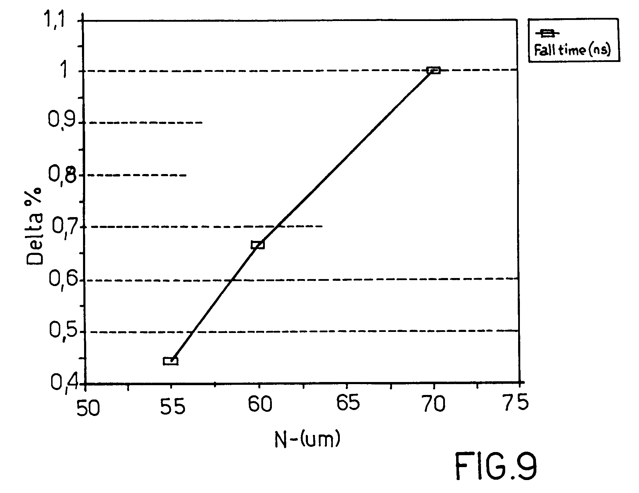

Figure 9 is a plot of fall time vs. X (N-); and

Figure 10 is a plot of Vcesat vs. X (N-).

## Detailed Description of the Invention

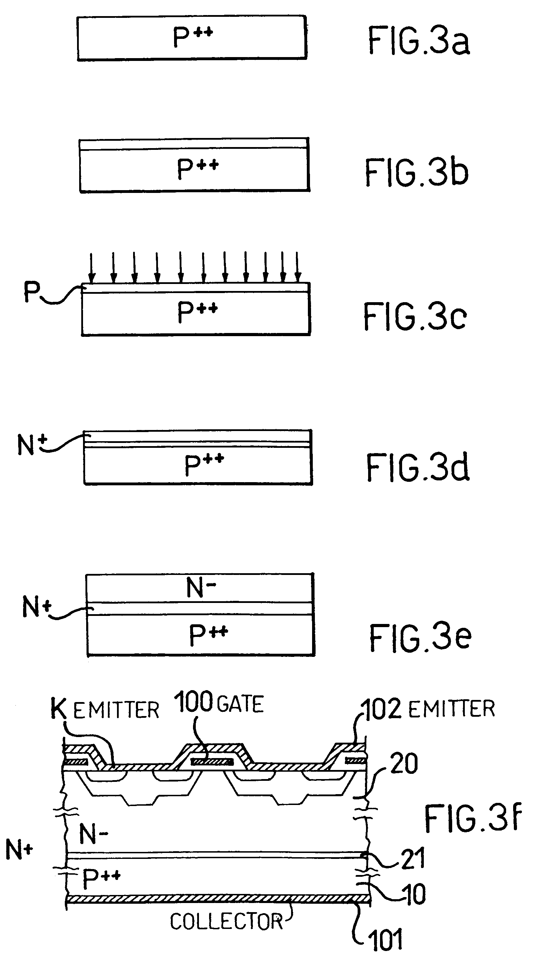

Figures 3a to 3f illustrate, not to scale, successive steps of the process used to make an IGBT device.

The invention solves the technical problem by providing a semiconductor power device which comprises an isolated gate bipolar transistor comprised of a semiconductor substrate 10 having a first type of conductivity and an overlying epitaxial layer 30 having a second type of conductivity, opposite from the first, and whose junction 21 to the substrate forms the base/emitter junction of the bipolar transistor, the junction 21 comprising a layer of a semiconductor material of the second type but having a higher dopant concentration than that of the epitaxial layer.

This device is characterized by the epitaxial layer 30 with conductivity of the second type having at least two zones of growing concentration, namely a first lower zone 22 being part of the junction and provided with a higher dopant concentration and a second upper zone provided with a lower concentration.

More particularly, the invention provides for the formation of an additional layer 22 whose concentration is intermediate between those of the N- layer 20 and the N+ layer 21.

This additional layer locates between the layer 23 of the device, namely the base 51 of the PNP transistor 60, and the buffer layer 21 which separates the base region 51 from the layer 10 constituting the emitter 50 of the PNP transistor 60.

Advantageously, this structure is directed to lower the electric field at the interface between the layers of the N- and N+ types corresponding to the layers 20 and 21 of the prior art and the layers 22 and 21 of this invention, down to values approaching zero.

In this way, the layer 23 can be formed with a very high resistivity, that is less heavily doped.

Thus, the thickness of the layer 23 can be greatly reduced, which contributes toward holding the same device breakdown voltage as per relation (1).

In particular, the layer 23 with N- conductivity is formed by epitaxially growing silicon doped (N-) with phosphorus to a resistivity and thickness which are dictated by the voltage value BV of the device to be produced.

The device of this invention has a layer 22 at a different concentration, intermediate that of the layer 23 with N-polarity and that of the layer 21 with N+ polarity.

In the example illustrated, the phosphorus concentration in the N- layer 20 according to the prior art is of 1.5E+14, whereas in the layer 23 according to the invention, the phosphorus concentration is of 9E+13.

The phosphorus concentration in the layer 21 has been left unchanged at 1E+17.

The additional layer 22 according to the invention has a phosphorus concentration of 5E+14.

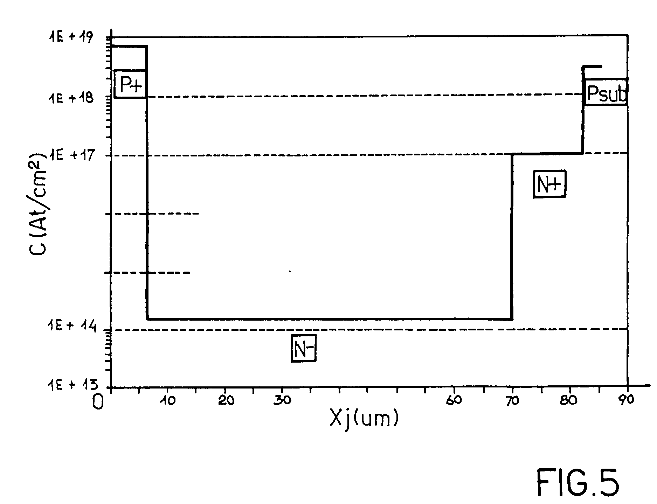

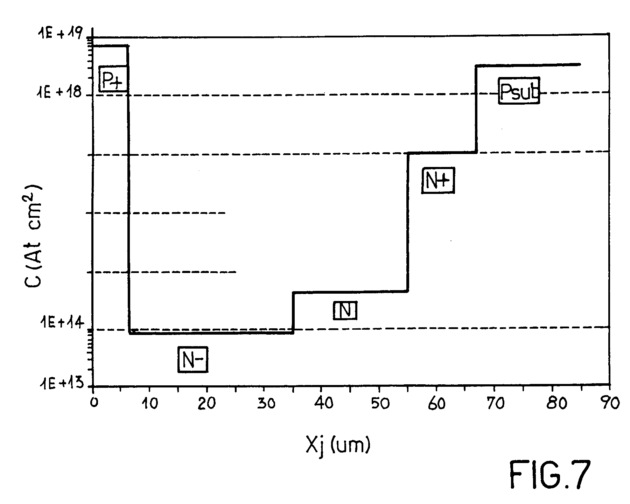

The concentration profile of the prior art and of the present invention are plotted in Figure 5 and Figure 7, respectively.

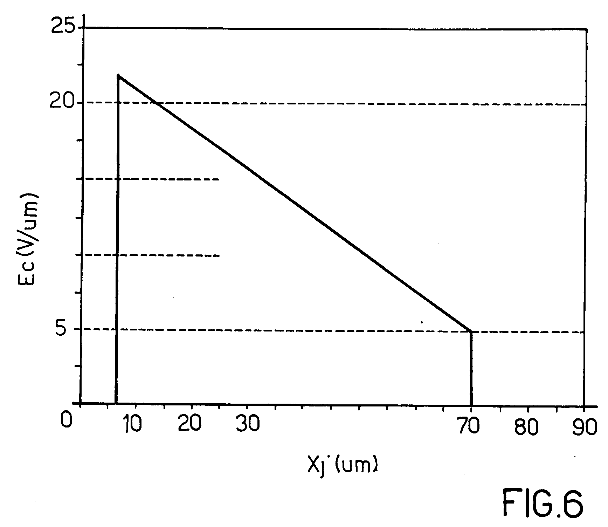

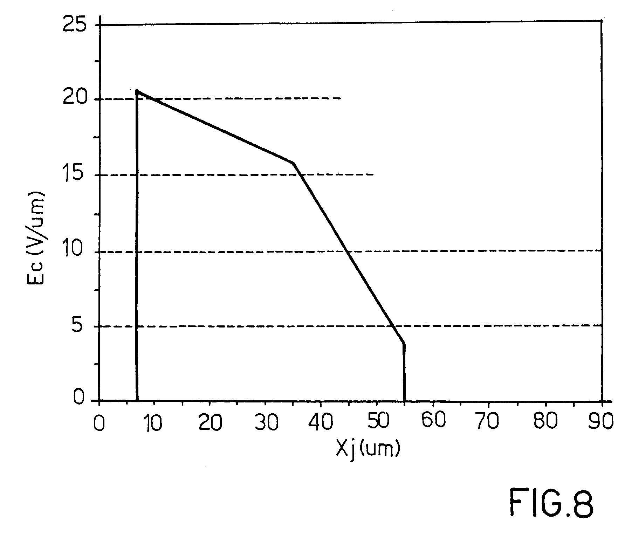

Figures 6 and 8 show the distribution of the electric field at breakdown voltage, respectively according to the prior art and this invention.

The values shown reveal on inspection that the inventive solution allows the overall thickness of the layer 30 to be reduced from 70 microns to 55 microns.

It can be shown that, for the same breakdown voltage, the combined thickness of the layer 23 and layer 22 is always smaller than that of the single layer 20.

Thus, it can be seen that with the solution provided by this invention, whereas the value of the electric field at the interface of the layers 20,21 was 5V/micron, the same electric field at the interface of the inventive layers 22, 21 is now 3V/micron, which brings out the improved ruggedness of the device of this invention.

Of the advantages of this invention which associate with the reduced thickness of the combined layer 30, Figure 15 shows that the fall time value becomes, for a 55-micron thickness of the layer 30, 0.45 times the value to be obtained with the thickness of 70 microns of the prior art layer 20.

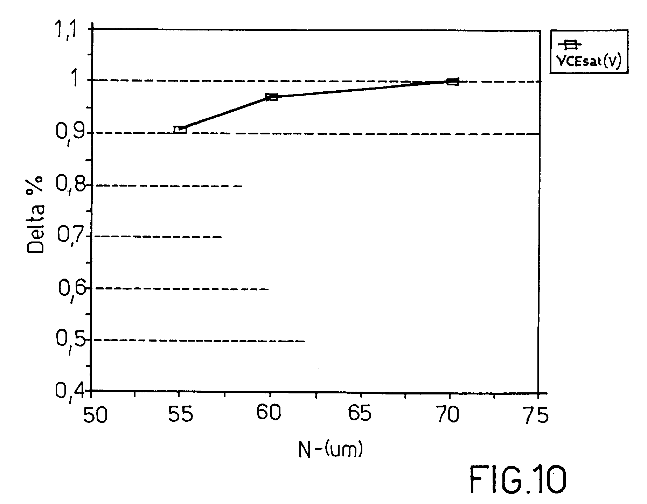

Figure 10 shows that the output resistance, or better the corresponding value of Vcesat, also benefits from the reduced thickness of the layer 30. In fact, it can be seen that the value of Vcesat, for a layer 20 according to the prior art which is 70 microns thick, has been reduced by approximately ten percent using a thickness of 55 microns for the layer 30 as allowed for by this invention.

It can be seen that the `improved parameters, Fall Time and Output Resistance, and ruggedness are, as previously mentioned, major merits of an IGBT device, so that the device according to the invention will perform much better than prior art devices.

It should be emphasized that techniques are used to form the additional intermediate layer which are readily available from the processing of IGBT devices, such as those used to form the layer 20 in the prior art.

It should be further noted that the particular technique used to form the layers 22, 23, 21 is ininfluential as to the results to be obtained.

It will be apparent to the skilled person in the art that the structure described may also be obtained using a semiconductor substrate with conductivity of the N type by reversing the conductivities of all the successive overlying layers from those described, so that the resultant device will be operated with all the applied voltages reversed in polarity with respect to the device described hereinabove.

It should be understood that the sequence described to arrive at the inventive structure may be modified in many ways without departing from the scope of the invention.

**Claims**

1. A semiconductor power device comprising an isolated gate bipolar transistor, which is comprised of a semiconductor substrate having a first type of conductivity and an overlying epitaxial layer having a second type of conductivity, which is opposite from the first, and whose junction to the substrate constitutes the base/emitter junction of the bipolar transistor, said junction comprising a layer of a semiconductor material of said second type but having a higher dopant concentration than that of the epitaxial layer, characterized in that the epitaxial layer with conductivity of the second type has at least two zones with different dopant concentrations, namely a first lower zone being part of the junction and having a higher dopant concentration and a second upper zone having a lower concentration.

2. A semiconductor device according to Claim 1, wherein the epitaxial layer has a thickness of less than 55 microns.

3. A semiconductor device according to Claim 1, wherein the electric field at the interface between the layer of semiconductor material having a higher dopant concentration than that of the epitaxial layer and the epitaxial layer has a value close to zero with respect to the values of the electric fields at the other interfaces present in the device.

4. A semiconductor device according to Claim 1, wherein the dopant concentration in the upper zone of the epitaxial layer is less than 1E+14.

5. A semiconductor device according to Claim 1, wherein the lower zone of the epitaxial layer, being part of the junction, has a thickness not exceeding 20 microns.

6. A semiconductor device according to Claim 1, wherein the lower zone of the epitaxial layer, being part of the junction, has a dopant concentration within the range of 1E+14 to 1E+15.

FIG.1

PRIOR ART

FIG.2

FIG.3a

FIG.3b

FIG.3c

FIG.3d

FIG.3e

FIG.3f

FIG.4

GATE

EMITTER

30

N+ | N+ | P+ | N+ | P | N+ | P+ | N+

P

23

22

21

N+

N−

N+

P+

SUBSTRATE

COLLECTOR

21

10

9

FIG.5

FIG.6

FIG.7

FIG.8

FIG.9

FIG.10

EP 0 746 040 A1

European Patent
Office

**EUROPEAN SEARCH REPORT**

Application Number

EP 95 83 0228

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | DE-A-43 26 052 (MITSUBISHI ELECTRIC CORP) 10 February 1994 * page 8, line 28 - page 9, line 43; figures 17-19 * | 1-6 | H01L29/739 |
| X | EP-A-0 594 049 (MITSUBISHI ELECTRIC CORP) 27 April 1994 * the whole document * | 1 | |
| A | DE-A-37 38 670 (NISSAN MOTOR) 26 May 1988 * the whole document * | 1 | |

TECHNICAL FIELDS
SEARCHED      (Int.Cl.6)

H01L

The present search report has been drawn up for all claims

| Place of search | Date of completion of the search | Examiner |
|---|---|---|
| THE HAGUE | 30 October 1995 | Mimoun, B |